Europäisches Patentamt

European Patent Office

Office européen des brevets

(19)

(11) Publication number: **0 039 507**
A1

(12) # EUROPEAN PATENT APPLICATION

(21) Application number: **81103382.8**

(22) Date of filing: **05.05.81**

(51) Int. Cl.³: **H 01 L 21/60, H 01 L 23/48**

(30) Priority: **05.05.80 US 146223**
**29.10.80 US 202342**

(43) Date of publication of application: **11.11.81**
**Bulletin 81/45**

(84) Designated Contracting States: **CH DE FR GB LI NL**

(71) Applicant: **LeaRonal, Inc., 272 Buffalo Avenue, Freeport, N.Y. 11520 (US)**

(72) Inventor: **Thomson, Donald Walter, 9 Gilder Court, Northport, N.Y. 11768 (US)**
Inventor: **Martin, James Leslie, 1616 Bascom Avenue, Merrick, N.Y. 11566 (US)**

(74) Representative: **Hansen, Bernd, Dr.rer.nat. et al, Hoffmann . Eitle & Partner Patentanwälte Arabellastrasse 4, D-8000 München 81 (DE)**

(54) **A process of packaging a semiconductor and a packaging structure for containing semiconductive elements.**

(57) Semiconductive circuit packages and process of packaging semiconductive circuits utilizing a first layer of goldsilver alloy with or without a second outer layer for wire lead bonding and also for silicon chip alloying when applicable.

- 1 -

A process of packaging a semiconductor and a packaging structure for containing semiconductive elements

The present application is a continuation-in-part of copending application Serial No. 146,223, filed May 5,1980.

The invention relates to a process of packaging a semiconductor and a packaging structure for containing semiconductive elements, utilizing a first layer of gold-silver alloy with or without a second outer layer for wire lead bonding and also for silicon chip alloying when applicable.

Semiconductor circuits are commonly produced on what is referred to as a chip or a die. These chips are generally composed of silicon or other crystalline semiconductor materials. The type of circuit placed on the chip will, of course, depend upon its end use. In utilizing these semiconductor circuits, the chips are mounted on a suitable base, connected generally by leads (wires) to suitable terminals and sealed, for example, with a plastic.

The mounts for the semiconductor or chips are referred to as headers or lead frames and are generally composed of nickel alloys, such as Kovar (an iron-nickel-cobalt alloy), or copper alloys. In order to obtain the proper bonding of the chip to the lead frame or header, the unit is first plated with 24 karat gold to a thickness generally of 40 to 50 micro inches (mi), the chip placed on the chip pad, and bonded to the pad by what is referred to as "alloying". To accomplish this alloying, the unit is heated to a temperature of between about 450 and 460°C. This process of metallurgically bonding the silicon chip to the gold deposit is often referred to as a gold/silicon eutectic die-attach procedure, since the actual temperature at which the alloying or bonding occurs is below the melting point of both the gold and the silicon, close to the eutectic temperature of the gold-silicon alloy system.

Another method of bonding the chips to the chip pads is by use of a cement, such as an epoxy cement, and in which case the cement curing is often accelerated by heating.

After the chip has been attached to the chip pad, the circuitry on the chip is connected to its proper terminals or welding pads or lands, generally by bonding 24 karat gold or other suitable metal wires to the appropriate portions of the chip circuitry and to the appropriate terminals.

The welding lands or terminals are also generally composed of a nickel alloy (e.g., Kovar) or copper alloy, and they are also plated with 24 karat gold to a thickness of about 40 to 50 mi to insure that a proper and strong connection is obtained to the circuitry via the gold wires.

Usually the package structure is integral and includes the gold plated chip pad and the gold plated welding lands or pads. Thus, when the alloying occurs, the entire structure is heated to about 450 to 460°C. This heat can cause diffusion of the base metals (Cu, Ni, Fe, Co, etc.) through the gold plating. The oxides of these metals formed on the surface can interfere with the bonding of the wires to the welding lands or pads as well as with the alloying of the chip to the chip pad. This diffusion phenomenon has thus required the use of 24 karat gold at thicknesses of 40 to 50 mi to effectively prevent diffusion of base metals to the surface of the gold plate on the welding lands and the chip pad.

Pure silver deposits have also been employed in the same manner. Pure silver, however, tarnishes and is subject to what is referred to as silver creep and is not as reliable as gold. Silver is plated to thicknesses ranging from 100 to 150 mi.

Obviously the electroplating of 24 karat gold on the units to the thicknesses of 40 to 50 mi is expensive and it would be highly desirable to find a way of reducing the amount of gold required to perform the alloying and wire bonding operations.

Unfortunately attempts to lower the karat value of the gold plating to as low as 18 karats, even at the same or substantially the same thicknesses, have not been successful. When 18 karat gold-silver alloys are used, the base metals diffuse to the surface of such a gold-silver alloy, forming oxides which interfere with the bonding of the chip to the chip pad and the wire leads to the welding lands.

## Summary of the Invention

This invention involves the discovery that a first layer of gold-silver alloy with or without further second outer layer not only can be used in place of the 24 karat gold or silver in packaging semiconductors, and more particularly in the bonding of silicon chips to chip pads, but also that such a low combined karat of a gold-silver alloy layer and, as the case may be, a 24 karat gold layer can be employed in substantially reduced combined thicknesses of less than about 50 mi, and from about 10-30 mi for the first gold-silver alloy layer with the second outer 24 karat gold layer, if utilized, being as thin as possible in accord with the criteria discussed herein, whilst retaining the advantageous properties of gold or silver electrodeposits, i.e., 1) alloying of the chip to the chip pad, 2) prevention of diffusion of base metals to the surface, and 3) bonding of metal wires between the chip and the weld pads.

Applicants have discovered that in order to insure that one achieves good alloying or bonding of the chip to the chip pad, that the use of only a gold-silver alloy layer will not be completely satisfactory. Applicants have theorized that the reason for this is that a gold-silver alloy will not form a good metallurgical bond with the silicon chip possibly becuase the silver hinders formation of a eutectic. In order to overcome this problem, it has been found possible to utilize as an intermediate layer what may be termed a preform of a gold alloy (i.e. gold-silicon eutectic) which is placed immediately upon the gold-silver alloy layer. This preform will adhere well to the gold-silver alloy layer and will also bond well to the applied silicon chip and in effect acts as a bonding bridge between the gold-silver alloy layer and silicon chip.

Alternatively, applicants have discovered that one may employ as a second outer layer a thin layer which is comprised of substantially pure gold. This outer layer may be of minimal thickness, i.e., about 5-15 mi. This second outer thin layer of substantially pure gold is placed immediately upon the gold-silver alloy layer, to which it bonds well, and it then forms a good bond with the subsequently applied silicon chip by forming the gold-silicon eutectic bond. In this case of course one need not utilize a gold- alloy preform. As with the preform, the thin gold layer acts as a bonding bridge.

As a further alternative, though less preferred, the second outer layer of either a preform of gold alloy or the thin layer of substantially pure gold may be placed on the back of the silicon chip, instead of on the gold-silver alloy layer, which will then be bonded to and upon the gold-silver alloy layer.

In the case of the bonding of metal wire leads between the chip and weld pads, the second outer layer, whether the preform of gold- alloy : layer or the thin layer of pure gold, is not required and may, if convenient, be omitted; in this case good bonding is achieved with only the gold-silver alloy layer.

It will be immediately observed that one of the main features of the invention is the ability to utilize a gold-silver alloy layer in substantial substitution for the previously employed pure gold layer which has traditionally been utilized as the bonding medium. This represents enormous economies. Such economies are realized even without taking into account that one is able to use reduced combined thickness of the gold-silver alloy and substantially pure gold (or the preform of gold alloy) as compared to the larger thickness of pure gold traditionally utilized. Stated otherwise, the present invention offers substantial savings in the amount of gold that need be used in the packaging of semiconductive circuits.

It is preferred that the combined karat value of the first and/or the second layers of the present invention be between about 10 and 17 karats. Higher or lower values may, however, be used. For instance, in the case of very rapid die attach or bonding procedures wherein little diffusion will occur, one may utilize a relatively very thin outer layer of pure gold and a relatively very thin layer of the gold-silver alloy of a low karat value, i.e., below about 17, with a resulting high combined karat value, even above 17. Under such conditions one can still achieve good bonding with minimal diffusion and yet realize substantial gold savings as compared to present practice wherein only pure gold is used in large thicknesses. On the other hand, very low combined karat value may be used, and particularly low karat gold-silver alloy layers, as in the case where the resulting silver creep or silver tarnish would not be objectionable. In each instance the only limiting factor is avoidance of diffusion of the base metal to the surface as would interfere with bonding.

To this end, it has been observed that detrimental diffusion of the base metal will be substantially avoided as long as that portion of the gold-silver alloy layer which is adjacent or close to the base metal at all times has a karat value below about 17 karats. By adjacent or close to the base metal it is meant in proximate location to the base metal or in proximate location to the strike layer on the base metal when a strike layer is employed.

In the case where a second outer layer of pure gold is to be used, determination of the thickness of each of the first gold-silver alloy layer and the second outer 24 karat gold layer, as well as the karat content of the first gold-silver alloy layer, can readily be established by one skilled in the art by merely adhering to the following criteria. The second outer 24 karat gold layer, which can be referred to as a flash layer, and whether placed on the chip pad, i.e., on top of the gold-silver alloy layer or on the chip itself, i.e., on the back of the chip, should be of a sufficient thickness as to permit the formation of a gold-silicon entectic bond as discussed earlier. It should not be overly thick as would entail the needless use of gold and might cause diffusion of the gold into the gold-silver alloy layer so as to raise the total karat value of the gold-silver alloy layer which, in turn, might permit diffusion upwards of the base metals, first into the gold-silver alloy layer and then into the second 24 karat gold outer layer and finally to the surface of the 24 karat gold outer layer. As noted, it has been observed in this regard that as long as the karat value of that portion of the gold-silver alloy layer which is at the interface with the base metal or at the interface of the strike layer on the base metal remains below about 17 karats, that diffusion of the base metals will not be a problem. In this regard, it can be seen that if substantial diffusion of the gold from the outer gold layer into the gold-silver alloy layer and adjacent to the base metal is to be expected--as in the case of long contact times or elevated die-attach bonding temperatures--then the initial karat value of the gold-silver alloy layer adjacent the base metal should be low so as to allow it to rise by virtue of diffusion from the outer gold layer and yet not finally exceed about 17 karats at the base metal or strike layer interface --in such a case also, the thickness of the inner gold-silver alloy layer may also be increased so as to allow gold diffusion into the alloy layer but not adjacent to the base metal interface. In such a case also the gold layer thickness should be increased slighly to account for diffusion of the gold into the alloy layer and to ensure that a good eutectic bond is formed.

As noted, the precise thickness of the first layer and the second outer layer for bonding of the chip to the chip pad can easily be determined and will also usually depend on the exact temperature at which the bonding takes place and the length of time that the package is exposed to the particular bonding temperature. Thus, for instance, and as concerns the second outer layer of pure gold, if a bonding temperature of about 450-460°C is applied for only a few seconds, then the thickness of the outer gold layer can be relatively small since little diffusion will take place, whereas if a higher temperature is used or longer contact times are employed then the gold thickness must be very slightly higher. The essential criteria in determining the thickness of the first layer and the second outer layer is the avoidance of diffusion of the base metals through the first and second layers to the surface and maintaining a low karat value at the base metal or strike layer interface. With the above criteria in mind, the desired thickness of both the first gold-silver alloy layer and the second outer gold layer can be readily determined.

Experience has demonstrated that satisfactory results are obtained when the first layer of gold-silver alloy is about 20 mi thick and has about 12 karat gold value and wherein the second outer 24 karat gold layer is about 10 mi thick. The combined karat value in this case is about 16 karats.

These low combined karat multi layer deposits have many of the advantages of the 24 karat gold deposits currently being used by the industry while at the same time significantly reducing the total amount of gold required. The low combined karat multi layers do not materially affect the electrical properties of the system. They are also solderable with conventional solder and capable of brazing for final encapsulation of the package, commonly called sealing. In addition all of these advantages can be obtained by use of the low combined karat multi layers at combined thicknesses substantially less than those conventionally employed today. In some cases due to the ability of the gold-silver alloy layer adjacent to the base metal to prevent base metal diffusion, as little as about 10 mi of the gold-silver alloy layer and as little as about 5 mi of the 24 karat gold layer, for a combined karat value of between about 10-17 karats can be used in place of 40-50 mi of 24 karat gold in use today, which again represents another significant saving in gold. The exact combined thicknesses are of course not determinative of the advantages of this invention since it is the ability to use less total gold as compared to the amount of gold used with conventional packages that brings about significant economic advantages.

## Brief Description of the Drawings

The drawings are illustrative of three fairly conventional packages for packaging semiconductor circuitry contained on silicon chips as non-limiting examples. The invention is not limited thereto but encompasses all types of packages in which electrodeposited gold or silver is employed.

Fig. 1 is a prospective view of a package referred to at times as a side braze dual inline package.

Fig. 1a is a side view of Fig. 1.

Fig. 2 is a bottom view of a different type package commonly referred to as a TO-5 package.

Fig. 2a is a side view of Fig. 2.

Fig. 3 is a prospective view of a flat type package generally referred to in the at as a lead frame.

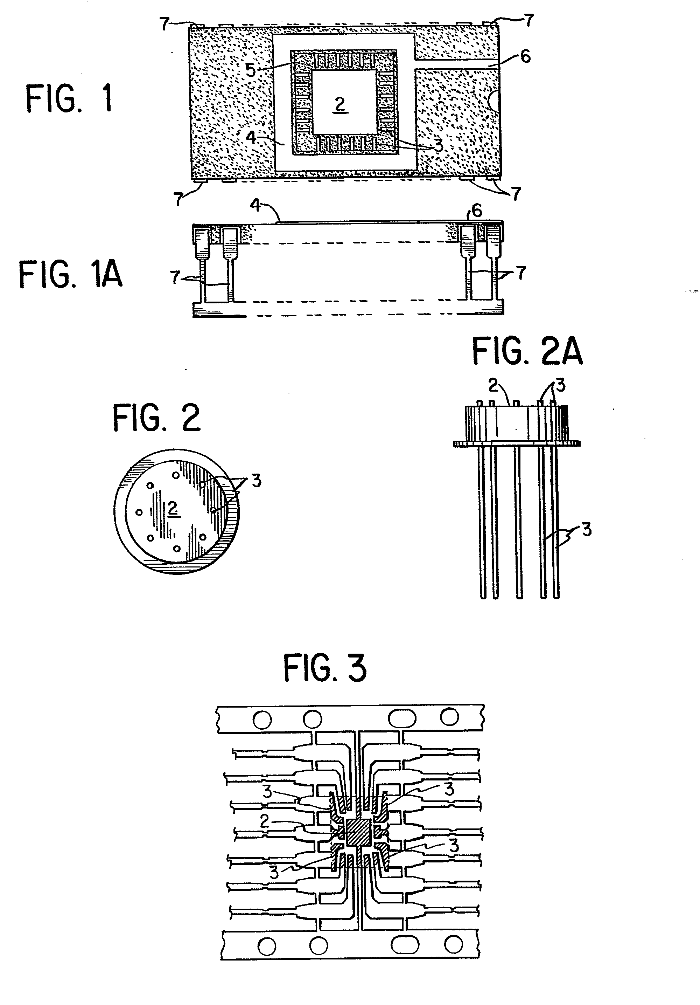

In Figs. 1, 2 and 3 there is a chip pad designated as 2 and welding lands or pads designated as 3. In Fig. 1 there are 24 welding lands, in Fig. 2 there are 8, and in Fig. 3 there are 14.

In the prior art chip pad and welding lands are generally electroplated with 24 karat gold to thicknesses of about 40 to 50 mi on a nickel or a nickel alloy, such as Kovar, as discussed above. In operation the silicon surface of the chip is place on the chip pads and the entire package heated to about 450 to 460°C to alloy the chip to the chip pad. The gold plated welding lands are thus subjected to this same heat treatment. After the chip has been alloyed (or attached) to the chip pad, the wire connections are made between the chip circuitry and the welding lands generally by means of suitable metal wires by conventionally well-known wire bonding techniques. The entire package is then sealed.

The package shown in Fig. 1 is sometimes referred to as a side braze dual inline package. Area 5 is ceramic. A conductive paint, such as a molybdenum-manganese alloy, is painted in the areas designated as 2, 3, 4 and 6 and baked into the ceramic. These baked-in areas are conductive and electrically connected to the strip 6 and the terminals 7. Since only the areas 2, 3, 4, 6 and 7 are

0039507

electrically connected, the package can be readily electroplated in the desired areas. This is conventionally accomplished by first plating the package in the desired areas with nickel, then with a 24 karat gold strike for adhesion purposes, and finally with 24 karat gold to a total thickness of 40 to 50 mi.

The border, designated as 4, is also conventionally of 24 karat gold (40 to 50 mi) to insure a hermetic seal with a gold plated lid after all of the wiring connections have been made.

In Fig. 2 the entire structure (commonly referred to as the TO-5 package) is made of Kovar and the welding lands 2 extending through the Kovar metal base are insulated with a ceramic. This entire package is conventionally gold plated with 24 karat gold, the chip alloyed to the chip pad 2, the pads 3 connected to the chip circuit by bonding metal wires thereto, and then hermetically sealed.

In Fig. 3 the base metal over which the gold is electroplated is copper or a copper alloy. The cross-hatched area is conventionally nickel plated (50-150 mi) followed by 24 karat gold plating of the chip pade 2 and the welding lands, again to a thickness of 40 to 50 mi's.

According to the present invention, the same conventional procedures can be followed in packaging semiconductors such as noted above with the exception that in the case of bonding the silicon chip to the chip pad the areas of the pad normally having a 24 karat gold deposit are replaced with a first layer of gold-silver alloy and either a second outer layer of either a preform of gold alloy

· or a layer of 24 karat gold. As noted, it is preferred that the layers have combined karat value between about 10 and 17 karats. As also discussed, a less preferred method is to place the outer eutectic layer or the 24 karat gold layer on the back of the silicon chip and to then join the thus coated chip to the pad coated with the gold-silver alloy. The bonding of wire leads to the welding land may be accomplished, if desired and convenient, with only the gold-silver alloy layer.

The invention is also applicable to packaging semiconductors where little or no heat is employed during the packaging operation and where the base metal diffusion into and through the gold deposit is not a significant factor. Thus, the invention can be practiced by adhering the silicon chips to the chip pad 2 by a heat or room temperature, curable cement or by eliminating the chip pad altogether, such as the pad 2 in Fig. 3. In the latter case a previously assembled ceramic chip circuit would merely have its lead wires connected to the welding lands 3. In such cases, it would only be necessary to deposit the gold-silver alloy layer on the welding lands. The savings in gold, due to the combined low gold content of the alloy layer and the reduced thickness of the deposit are still very significant, while unexpectedly retaining good bonding characteristics with gold wire leads from the semiconductor circuit.

The prior art uses 24 karat gold wires for connecting the semiconductive circuit to the welding lands to insure a good bond between the wires and the lands. As noted, this invention also includes the use of low karat (e.g., about 10 to 17 karat) gold-silver alloy wires for making these connections by conventional procedures.

-13-

## Description of the Preferred Embodiments

The invention, in essence, involves the use of a relatively low karat gold-silver alloy layer electrodeposit with or without a second outer layer, in conventional semiconductor packaging in place of the 24 karat gold or pure silver deposits in use today. The gold-silver first layer and the second outer layer according to this invention can be used at combined reduced thicknesses over those conventionally in use today and although this is not necessary according to this invention it is obviously very desirable.

The invention can be practiced, in the case of bonding the silicon chip to the chip pads, by first electrodepositing the gold-silver alloy layer on various substrates which are used to form the package and, in the case where the outer layer is to be pure gold, thereafter electrodepositing thereon the 24 karat gold layer. The particular substrate is not a limiting factor according to the invention. As a practical matter, the substrates used by the semiconductor industry today are fairly standard and include copper, copper alloys, nickel and nickel alloys, such as Kovar (29% nickel, 17% cobalt, 53% iron and 1% minor ingredients, impurities). Iron-nickel-chromium alloys have also been used.

The limiting factor of the substrates in the industry is due to reasons other than the electrodeposition of metals such as gold. With the TO-5 package, for example, the leads 3 are insulated by a ceramic such as $SiO_2$ and the base alloy chosen is generally Kovar because its thermal coefficient of expansion is fairly close to that of the ceramic insulation thus retaining isolation of the metal parts from one another. The base metal or alloy must also withstand the alloying temperatures employed
when the chip is attached, e.g., 450-460°C.

The first layer of gold-silver alloy of the desired
karat and thickness can be directly electroplated on the
substrate with the second outer 24 karat layer then
electroplated on the first layer with the two layers, if
desired, then being fused by heat.  The preform gold
alloy    layer may be similarly attached to the gold-silver
alloy layer.  Multiple separate gold-alloy layers of
different karat can also be applied, with the resulting
multiple layers fused together to form composite integral
layers or deposits of the desired karat and thickness; if
a second pure gold outer layer is to be used, it may then
be fused thereon.  Multiple deposits or layers of pure
gold and pure silver can also be electrodeposited on the
substrate and fused together to form the desired composite
provided, however, that in the case of bonding the chip to
the chip pads and where a second pure gold outer layer is
to be used, then the outer layer or surface is a layer of
pure gold of the necessary thickness as previously discussed.

In practicing the invention it is generally desirable
(depending on the surface to which the gold-silver alloy
is to be plated) to first plate the surface with a gold or
silver strike to a thickness of between about 3 to 5 mi to
improve adhesion of the gold-silver alloy plating layer to
the surface.  It will thus be recognized that any mention
herein of a first layer of gold-silver alloy layer is
without reference to the use of a previus strike layer.
If the first gold-silver alloy layer has a sufficient
adhesion to the surface being plated, no previous strike
plating would be required and the gold-silver alloy of the
desired karat may be directly plated on the surface.  When using a gold or silver strike, the amount of metal in the strike layer must be taken into account when determining the total karat, since, as noted above, the strike deposit can be fused into any gold, silver or gold-silver alloy deposited over the strike deposit.

Various gold, silver and gold-silver alloy baths can be used to form the first layer deposits. The baths used are in fact not critical to the invention. Some of the baths used in the Examples contained brightening agents and/or dispersing agents simply because these baths were readily available at the time.

The use of the first gold-alloy layer with or without the subsequent second outer layers according to this invention for the bonding of the chip to the chip pad still permits the use of conventional thermal compression, or thermal sonic bonding of metal wires to the welding lands or pads having the gold-silver alloy layer deposited thereon. The alloying technique used to attach the chip, e.g., silicon, may have to be slightly altered depending on the combined karat of the gold-silver alloy layer and the nature of the second outer layer that is employed as compared to that conventionally used with only the 24 karat deposits.

## Example 1

500 TO-5 components such as described in Fig. 2 were cleaned and pretreated in the conventional manner and were plated with a 24 karat gold strike of 5 mi. The components were then barrel plated with a gold-silver alloy in a five-gallon bath of the following makeup:

| | |
|---|---|
| Gold (as potassium gold cyanide) | 8.2 g/l |
| Silver (as potassium silver cyanide | 3.5 g/l |
| Free potassium cyanide | 60.0 g/l |
| Amino guanidine bicarbonate | 3.6 g/l |
| (added as a solution of the phosphate salt) | |

The guanidine was added to deionized water and the pH adjusted to 10. The potassium cyanide was added followed by the gold and silver as potassium cyanide complexes. The solution was raised to final volume and the pH adjusted to 10.5. The current density used was 0.75 amps per sq. ft. and time of plating was 15 minutes.

The resulting alloy deposit is 15 mi (12 karat, 50% Au). The TO-5 components were then subjected to a 500°C heat soak in air for 5 minutes and examined by eye and under low power magnification for evidence of diffusion of the base Kovar alloy metals into the gold-silver alloy plating which would cause discoloration of the surface. No evidence of such discoloration or diffusion was found.

During the heat soak, the gold-silver alloy deposit and the 24 karat gold strike layer fused together to a good degree making the total deposit about 20 mi in thickness and the total karat about 16 (66.6% Au).

## Example 2

A semiconductor package, such as shown in Fig. 1 and 1a, after having been fabricated to the point where the areas 2, 3 and 4 have been rendered electrically conductive with an alloy such as molybdenum-manganese, cleaned and pretreated in the conventional manner, was plated with nickel from a conventional nickel sulfamate bath to an average thickness of 150 mi. The conductive areas were then plated with a 24 karat gold strike to a thickness of 5 mi in a conventional cyanide gold strike bath. The package was then plated with the same gold-silver alloy bath as set forth in Example 1 to thickness of 60 mi. The gold-silver alloy coating was 12 karat (50% Au). The current density was 1 amp/sq. ft. and the plating time 45 minutes. The composite karat of the alloy and 24 karat gold strike was 13.4 (55.9% Au). The semiconductor package was heated in air at 500°C for 5 minutes. There was no visible discoloration on the surface of the alloy deposit indicating no diffusion of the nickel metal to the surface.

## Example 3

Nickel-iron alloy substrates (42% Ni) were cleaned and pretreated in the conventional manner and then plated with a conventional pure silver bath at 5 amp/sq.ft. for 45 seconds to deposit a plating thickness of 10 mi. The bath contained 36 g/l of silver as potassium silver cyanide, 100 g/l of potassium cyanide and 15 g/l of potassium carbonate. The bath as actually used (because it was readily available) contained a brightening agent (approximately 1 ppm selenium as potassium selenocyanate) and a wetting agent (0.25-0.5 g/l sodium lauryl sarconsinate) conventionally used for depositing lustrous silver. In practice, however, these materials can be eliminated since bright silver is not absolutely necessary for this application.

The silver plated substrates were then plated in a gold bath containing 12.0 g/l of gold as potassium gold

-18-

cyanide, 60 g/l of boric acid, and 30 g/l mono potassium phosphate at a current density of 100 amp/sq.ft. for 2 seconds to deposit 10 mi of pure gold over the silver. The composite karat was 15.5 (64.8% Au).

The plated substrates were then heated in air at 500°C for 5 minutes (causing fusion of the silver and gold layers to form the composite layer). No visible diffusion of the base metal to the surface was observed. The composite surface now had the color of a silver-gold alloy.

## Example 4

Nickel-iron alloy component substrates were cleaned and pretreated in the conventional manner and then strike-plated with a pure gold bath to deposit a gold strike layer of approximately 3-5 mi. Thereafter, the strike-plated substrates were plated with a gold-silver alloy from a bath of the following makeup:

| | |
|---|---|
| Gold (as potassium gold cyanide) | 14.5 g/l |
| Silver (as potassium silver cyanide) | 4.5 g/l |
| Boric Acid | 30 g/l |
| Potassium Phosphate | 35 g/l |
| pH 7.0 | |
| Temp. 60°C | |

The substrates were spot plated using the above solutions in high speed plating equipment at 150 ASF and for 2 seconds to deposit a gold-silver alloy layer of approximately 10-20 mi. The components were then plated with a pure gold layer to a thickness of about 10 mi.

Silicon chips were thereafter die=attached to the plated substrates with completely satisfactory bonding between the chips and the pads with no observed diffusion of the base metal to the surface.

## Example 5

Example 4 was repeated except that the gold outer layer was omitted. Completely satisfactory wire bonding between the chips and the pads again resulted with no diffusion of the base metal to the surface being observed.

We Claim:

1. A process of packaging a semiconductor in which the package includes welding lands which comprises electroplating the welding lands with a gold-silver alloy and connecting wire leads from the semiconductor circuitry to the welding lands.

2. The process of claim 1 wherein the combined karat value of the gold-silver alloy is between about 10 and 17 karats.

3. The process of claim 1 in which the welding lands to be plated with the gold-silver alloy is constructed of or plated with copper, a copper alloy, nickel or a nickel alloy.

4. The process of claim 1 in which the thickness of the gold-silver alloy is less than about 50 mi.

5. A process of packaging a semiconductor in which the package comprises a chip pad and welding lands, both of which are constructed of or plated with a non-noble metal, which comprises electroplating the chip pad and the welding lands with a first layer of gold-silver alloy, alloying a semiconductor to the chip pad at a temperature sufficiently high to cause adherence of the semiconductor to the pad, and connecting wire leads from the semiconductor circuitry to the welding lands.

6. The process of claim 5 wherein the chip pad is electroplated with a second outer layer of 24 karat gold.

7. The process of claim 6 wherein the welding lands are also electroplated with the second outer layer of 24 karat gold.

8.   The process of claim 5 wherein the karat value of the gold-silver alloy adjacent or close to the non-noble metal is at all times below about 17 karats.

9.   The process of claim 5 wherein the combined karat value is between about 10 and 17 karats.

10. The process of claim 5 in which the non-noble metal is copper, a copper alloy, nickel or a nickel alloy.

11. The process of claim 5 in which the semiconductor is composed of silicon.

12. A process of packaging a semiconductor circuit in which the package comprises a chip pad and welding lands, both of which are constructed of or plated with a non-noble metal, which comprises electroplating the chip pad and welding lands with layers of pure gold, pure silver or gold-silver alloy, adjusting the total gold content of the layers so that when the layers are fused together by heat, the composite integral layers have a gold karat between about 10 and 17 karats, and fusing the layers together by heat.

13. The process of claim 12 wherein the outer layer of the chip pad is a layer of 24 karat gold.

14. The process of claim 13 wherein the outer layer of the welding lands is also a layer of 24 karat gold.

15. The process of claim 12 in which the non-noble metal is copper, a copper alloy, nickel or a nickel alloy.

16  The process of claim 12 in which the semiconductor is composed of silicon.

17. A process of packaging a semiconductor circuit in which the package comprises a chip pad and welding lands, both of which are constructed of or plated with a non-noble metal, which comprises electroplating the chip pad and the welding lands with multiple layers of pure gold, pure silver or gold-silver alloy, adjusting the total gold content of the layers so that the composite integral layers would have a combined karat between about 10 and 17 karats, placing a semiconductor on the electroplated semiconductor pad, alloying the semiconductor to the pad at a temperature sufficiently high to cause fusion of the semiconductor to the pad, and causing the electrodeposited layers to fuse together thus forming integral composite layer having a gold karat value between about 10 and 17 karats.

18. The process of claim 17 wherein the outer layer of the chip pad is a layer of 24 karat gold.

19. The process of claim 18 wherein the outer layer of the welding lands is also a layer of 24 karat gold.

20. The process of claim 17 in which the non-noble metal is copper, a copper alloy, nickel or a nickel alloy.

21. The process of claim 17 in which the semiconductor is composed of silicon.

22. A package structure for containing semiconductive elements comprising a chip pad and welding lands, both of which are constructed of or plated with a non-noble metal, and having a first layer of gold-silver alloy.

23. The package of claim 22 wherein the chip pad has a second outer layer of 24 karat gold.

24. The package of claim 23 wherein the welding lands also have a second outer layer of 24 karat gold.

25. The package of claim 22 wherein the karat value of the gold-silver alloy adjacent or close to the non-noble metal is at all times below about 17 karats.

26. The package of claim 22 wherein the combined karat value is between about 10 and 17 karats.

27. A package structure for containing semiconductive elements comprising a chip pad and welding lands, both of which are constructed of or plated with a non-noble metal, and having deposited on the pad and lands multiple layers of pure gold, pure silver, or gold-silver alloy, and in which the combined gold content of the layers represent a gold karat of between about 10 and 17 karats, said layers being capable of being fused together by heat to form integral composite layer having a combined gold karat value between about 10 and 17 karats.

28. The package of claim 27 wherein the outer layer of the chip pad is a layer of 24 karat gold.

29. The package structure of claim 28 wherein the outer layer of the welding lands is a layer of 24 karat gold.

30. A package structure for containing semiconductive · elements comprising a chip pad and welding lands, both of which are constructed of or plated with a non-noble metal, and having deposited on the pad and lands a first layer of gold-silver alloy, and having deposited on the pad a second outer layer of 24 karat gold and having a combined karat value between about 10 and 17 karats, a semiconductive element adhered to the chip pad via the first and second layers, and wire leads connected from the semiconductive element to the welding lands and bonded thereto via the gold-silver alloy layer deposited on the lands.

31. The package structure of claim 30 wherein the welding lands also have deposited thereon a second outer layer of 24 karat gold.

32. A package structure for containing semiconductive elements comprising welding lands and having a gold-silver alloy layer of a karat value between about 10 and 17 deposited on the welding lands.

33. The package of claim 32 in which the welding lands plated with the gold-silver alloy layer are constructed of or plated with copper, a copper alloy, nickel or a nickel alloy.

34. The package of claim 32 in which the thickness of the gold-silver alloy layer is less than about 50 mi.

**FIG. 1**

**FIG. 1A**

**FIG. 2A**

**FIG. 2**

**FIG. 3**

## DOCUMENTS CONSIDERED TO·BE RELEVANT

| Category | Citation of document with indication, where appropriate, of relevant passages | Relevant to claim |
|---|---|---|
| | US - A - 3 593 412 (MOTOROLA, INC.)<br><br>-- | 1-34 |
| | US - A - 3 050 667 (SIEMENS-SCHUCKERT-WERKE AG)<br><br>-- | 1-34 |
| | US - A - 4 142 203 ((AVX CORP.)<br>* column 1, line 44 to column 2, line 15; column 3, line 9 to column 4, line 14; column 4, line 57 to column 5, line 26 *<br><br>-*- | 1-34 |
| A | US - A - 3 158 471 (INTERNATIONAL RECTIFIER CORP.)<br><br>-- | |
| A | SOLID-STATE TECHNOLOGY, Vol. 21, No. 2, February 1978, New York<br>W.A. FAIRWEATHER, "Alloy Gold Deposits for Electronic Applications"<br>pages 54 to 58, 76<br>* page 56, second paragraph *<br><br>---- | |

**CLASSIFICATION OF THE APPLICATION (Int. Cl.3)**

H 01 L 21/60
H 01 L 23/48

**TECHNICAL FIELDS SEARCHED (Int. Cl.3)**

H 01 L 21/58
H 01 L 21/60
H 01 L 21/88
H 01 L 23/12
H 01 L 23/48
H 01 L 23/54

**CATEGORY OF CITED DOCUMENTS**

X: particularly relevant
A: technological background
O: non-written disclosure .
P: intermediate document
T: theory or principle underlying the invention
E: conflicting application
D: document cited in the application
L: citation for other reasons

&: member of the same patent family, corresponding document

| X | The present search report has been drawn up for all claims | | |
|---|---|---|---|
| **Place of search**<br>Berlin | **Date of completion of the search**<br>03-08-1981 | **Examiner**<br>GIBBS | |

EPO Form 1503.1  06.78